# EUROPEAN PATENT APPLICATION

(11) **EP 4 815 249 A1**
(43) Date of publication of application: **30.09.2026**
(21) Application number: 25167084.0
(22) Date of filing: 28.03.2025
(51) Int. Cl.: H02J 7/00, G01R 31/392, H01M 10/44, H02J 7/34

(54) **BATTERY HEALTH MONITORING FOR PULSE LOAD POWER SUPPLIES**

(71) Applicant: NXP B.V., 5656 AG Eindhoven (NL)
(72) Inventor: SNIJDER, Bart, 5656AG Eindhoven (NL); VILLAR PIQUÉ, Gerard, 5656AG Eindhoven (NL)
(74) Representative: Schwarzweller, Thomas

(57) **Abstract**

Disclosed is a method of detecting a health state of a battery, in a power supply circuit having a charger and an energy storage device and for a pulsed load having a repetition interval, the method comprising: controlling a charging current of the energy storage device, by controlling an operating frequency of the charger, to recharge the energy storage device over the repetition interval at an optimised charger operating frequency; at least one of: comparing the optimised charger operating frequency with a threshold frequency, and comparing a rate-of-change of the optimised charger operating frequency with a threshold rate-of-change; and indicating an end-of-life state of the battery in response to at least one of: the optimised charger operating frequency exceeding the threshold frequency, and the optimised charger operating frequency exceeding the threshold rate-of-change. Other embodiments are disclosed.

## Description

### FIELD OF THE DISCLOSURE

The present disclosure relates to power supplies and methods for providing energy pulses to a load having a pulsed load profile.

### BACKGROUND

Various electrical applications require a pulsed energy supply. Nonlimiting examples include industrial and medical pumps, for providing, periodically, a rotation or translation of part of a machine. One such application is that of medical dosimetry, for intermittent or periodic application, or dose, of a fluid such as a painkiller or insulin.

Increasingly, medical dosimetry devices such as insulin pumps are being developed to be lightweight and portable, or even internal to the patient, or subcutaneous. The supply of power to such devices is subject to an increasingly stringent set of constraints; for example, devices which are internal to the patient cannot be readily accessed to change a battery. Moreover, there may well be space or volume constraints. The intermittent power requirement on such devices may be relatively high, for instance an energy pulse may be required to be delivered in a relatively short space of time, corresponding to a relatively high power delivery level, and such devices typically include an intermediate energy storage device which is able to provide an energy pulse at a high power level and be slowly recharged or "trickle charged" from an energy or power source such as battery which may not be up to provide such a high power Battery lifetime is of increasing importance for such devices, as a result of which, it may be helpful to include battery health monitoring in such resource-constrained devices.

### SUMMARY

According to a fist aspect of the present disclosure, there is provided a power supply circuit, for a pulsed load and comprising: a battery; an energy storage device, connected to an output of the power supply circuit and configured to provide periodic current pulses to the load at a repetition interval; a charger connected, at an input thereof, to the battery, and at an output thereof to the energy storage device, and configured to provide a charging current to the energy storage device; a charge controller, configured to control the charging current by controlling an operating frequency of the charger, and to determine an optimised charger operating frequency at which the energy storage device is recharged over the pulse interval; and a health monitor configured to at least one of: compare the optimised charger operating frequency with a threshold frequency and indicate an end-of-life state of the battery in response to the optimised charger operating frequency exceeding the threshold frequency; and compare a rate-of-change of the optimised charger operating frequency with a threshold rate-of-change and indicate an end-of-life state of the battery in response to the rate-of-change of the optimised charger operating frequency exceeding the threshold rate-of-change. By using the operation frequency of the charger as an indicator of the state of the battery the power supply circuit may provide health monitoring inexpensively and without the requirement for additional circuitry or components.

In one or more embodiments the energy storage device is a capacitor. A capacitor represents a particular simple form of energy storage device; however the present disclosure is not limited thereto, and may, for example use a secondary battery, electrochemical cell, or other form of energy storage.

In one or more embodiments the charger is a DC-DC converter, and the charge controller is configured to operate the DC-DC converter in a pulse frequency modulation, PFM, mode. Typically, the PFM mode comprises a constant on-time.

In one or more embodiments the charge controller is configured to determine the optimised charger operating frequency at a start of each load pulse. This may avoid complexities arising through a possible variation of the optimal charging current throughout a recharging interval.

In one or more embodiments the power supply circuit is for an additional load, which, over the repetition period, is less than one quarter of the pulsed load. In preferred embodiments, any constant load should be small relative to the pulsed load, in order not to hide or mask the effect of the pulses on the PFM operating frequency, although the disclosure is not limited thereto.

In one or more embodiments in which the health monitor compares the optimised charger operating frequency with a threshold frequency, the threshold frequency is a pre-determined multiple of a start-of-life optimised operating frequency. The multiple need not be an integer multiple, but may for instance be 1.5 times the start-of-life optimised operating frequency, or 4 times the start-of-life optimised operating frequency.

In one or more embodiments in which the health monitor compares the rate-of-change of the optimised charger operating frequency with a threshold rate-of-change, the threshold rate-of-change of the frequency is a pre-determined multiple of a start-of-life rate-of-change of the optimised operating frequency. The multiple need not be an integer multiple, and may for instance be 10 times the start-of-life rate of change, or 20 times the start-of-life rate of change. However, the value may be dependent on the application; in some applications, it may be 100s or even 1000 times the start-of-life rate of change. In other embodiments, the threshold rate of change may be an absolute level, rather then dependent on an initial rate-of-change, particularly in applications in which the latter may be very small.

In one or more embodiments, the battery is a primary alkaline, also referred to as alkaline-manganese oxide, battery. However, the disclosure is not limited thereto, and in other embodiments, the battery may be another type of dry-cell chemical-based energy storage system, such as, without limitation, Lithium ion, or Nickel-Cadmium (NiCad) batteries. The skilled person will thus understand that as used herein, the term battery is to be interpreted broadly.

According to a second aspect of the present disclosure, there is provided a method of detecting a health state of a battery, in a power supply circuit having a charger and an energy storage device and for a pulsed load having a repetition interval, the method comprising: controlling a charging current of the energy storage device, by controlling an operating frequency of the charger, to recharge the energy storage device over the repetition interval at an optimised charger operating frequency; at least one of: comparing the optimised charger operating frequency with a threshold frequency, and comparing a rate-of-change of the optimised charger operating frequency with a threshold rate-of-change; and indicating an end-of-life state of the battery in response to at least one of: the optimised charger operating frequency exceeding the threshold frequency, and the rate-of-change of the optimised charger operating frequency exceeding the threshold rate-of-change.

In one or more embodiments, the repetition interval is a first repetition interval, and the at least one of a threshold frequency and a threshold rate-of-change are a first threshold frequency and a first threshold rate-of-change respectively, the pulsed load further having a second repetition interval, for which the at least one of a threshold frequency and a threshold rate-of-change are a second threshold frequency and a second threshold rate-of-change respectively. In one or more embodiments, the second threshold rate-of-change is equal to the first threshold rate-of-change. In one or more embodiments, the energy storage device is a capacitor. In one or more embodiments, the charger is a DC-DC converter, and controlling the charger comprises operating the DC-DC converter in a pulse frequency modulation, PFM, mode.

In one or more embodiments, the PFM mode comprises a constant on-time. In one or more such embodiments, the DC-DC converter is operating in discontinuous conduction mode, DCM, having a variable idle-time. In one or more embodiments the optimised charger operating frequency is determined at a start of each load pulse. In one or more embodiments power supply circuit is for an additional constant load.

In one or more embodiments which include comparing the optimised charger operating frequency with a threshold frequency, the threshold frequency may be a pre-determined multiple of a start-of-life optimised operating frequency. In one or more other embodiments, which include comparing the rate-of-change of the optimised charger operating frequency with a threshold rate-of-change, the threshold rate-of-change may be a pre-determined multiple of a start-of-life rate-of-change of the optimised operating frequency.

### BRIEF DESCRIPTION OF THE DRAWINGS

Reference will now be made to the accompanying drawings, wherein:
FIG. 1 illustrates, schematically, a circuit including a load which requires a pulsed energy supply;
FIG. 2 shows a power supply circuit according to one or more embodiments of the present disclosure;
FIG. 3 shows, conceptually, a secondary control loop;
FIG. 4 shows the effect of the control in the case of a decrease in the repetition rate of load pulses;
FIG. 5 show a schematic plot over time of a supply voltage of the battery and a PFM frequency of the charger;
FIG. 6 show a schematic plot over time of a supply voltage of the battery and a PFM frequency of the charger, under two different operating conditions;
FIG. 7 illustrates the effect of variation of charging current across charging intervals for two different periodicities of load pulses;
FIG. 8 shows a various signals, illustrating operation of a power supply circuit during transition between load conditions;
FIG. 9 plots the change, in charging current between successive load pulses against value or magnitude of the change in the repetition rate, for various control methods; and
FIG.10 shows various signals similar to those in FIG. 4, resulting from a decrease in the periodicity of the load pulses, and

It should be noted that the FIG. s are diagrammatic and not drawn to scale. Relative dimensions and proportions of parts of these FIG. s have been shown exaggerated or reduced in size, for the sake of clarity and convenience in the drawings. The same reference signs are generally used to refer to corresponding or similar features in modified and different embodiments.

### DETAILED DESCRIPTION

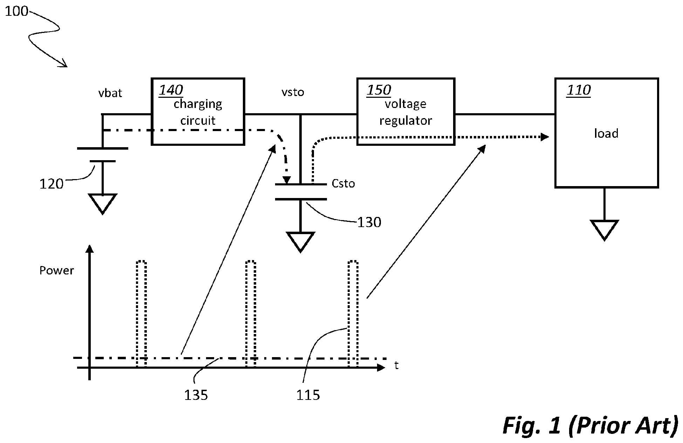

FIG. 1 illustrates, schematically, a circuit 100 including a load 110 which requires a pulsed energy supply. As illustrated, the load requires a pulsed supply of energy comprising periodic, or intermittent energy, pulses 115. The load is an example of a heavily duty-cycled system which achieves very low power consumption on average, for instance by remaining in an "off" or "sleep" mode for long periods until an event or time signal wakes them up, such that they can execute an operation or activity requiring the pulse of energy for a short time and go back to sleep.

Energy is provided to the load from a power supply, in this case a battery 120. In the context of a small or weak energy or power source, such as a small battery or small energy scavengers with limited output power, it is typically required to have in the system a reservoir of energy, such as energy storage device or unit 130, which can accumulate the low power provided by the energy or power source during the long sleeping times, and supply the peak power required by the load to perform its activity. Energy storage unit 130 may be, as shown, a capacitor, or a group of capacitors. A common approach is to charge the capacitor slowly, as illustrated at 135, either directly from the energy or power source or battery 120, or via a charging circuit 140 such as a DC-DC converter. The details of the circuit may depend on the size of the capacitor, the required stability of the voltage supply to the load, and the required energy efficiency of the process overall. A voltage regulator 150, or other means to separately control the energy from the energy storage device or unit 130 to the load 110, may be provided.

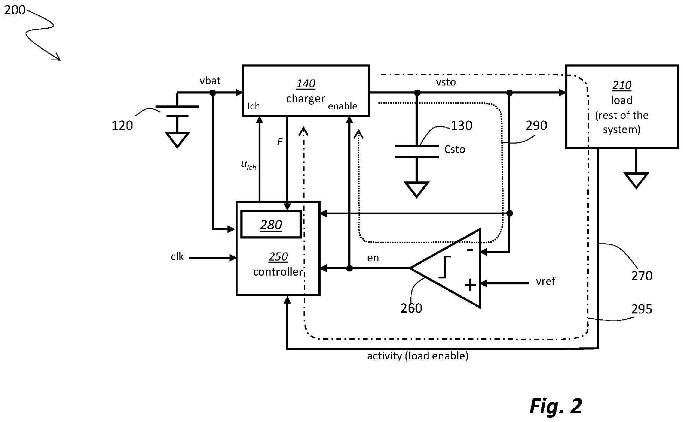

FIG. 2 shows a power supply circuit for providing an optimised charging current to the energy storage device 130. A power supply or battery 120 supplies a current at a voltage vbat to a charger or charging circuit 140 which provides a periodic charging pulse to the energy storage device 130. A wide range of different charging devices could be applied: typically, the charge or charging circuit 140 is a DC-DC converter, such as an inductor-based DC-DC converter, or a switched capacitor converter.. When enabled, the charging circuit provides a charging current to the capacitor or energy storage device or unit 130 at a variable voltage of vsto. The charging circuit 140 is enabled or disabled according to the state of the output en of a comparator 260, which compares the voltage vsto with a reference voltage vref. The enabling/disabling thus may be described as an inner, or primary, control loop 290. The power supply circuit 200 includes a feedback mechanism 270, which may as shown be from the load 210 or rest of the system, to a controller 250. The feedback mechanism 270 is indicative of a repetition rate of pulses of the pulsed load. The controller 250 controls the charging circuit, and in particular the charging current Ich supplied by the charging circuit, in dependence on the repetition rate of the pulse load. The controller is configured to change the charging current in response to a change in the repetition rate of the pulsed load. The power supply circuit thus implements a secondary, or outer, control loop 295 which modifies the charging current in dependence on the state of the system. In particular, the controller 250 may adjust the charging circuit 140 to supply a higher charging current in response to an increase in the repetition rate of the pulses of the load, and to supply a lower charging current in response to a decrease in the repetition rate of the pulses of the load. According to the present disclosure, the controller 250 includes a health monitor 280 which is configured to identify an end-of-life state of the battery 120, as will be described in more detail hereinbelow.

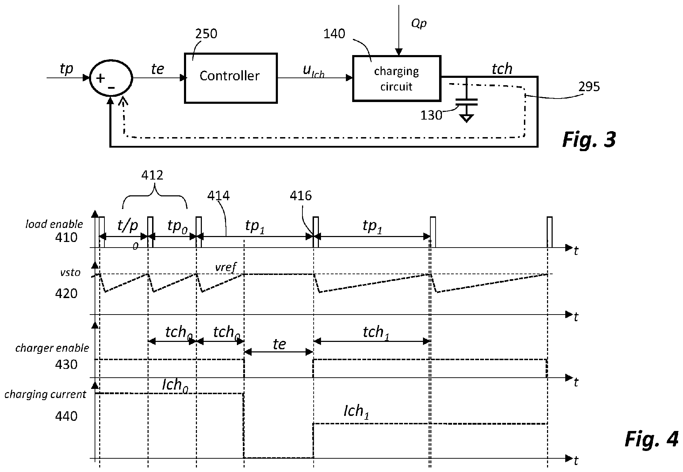

FIG. 3 shows, conceptually, the secondary control loop 295. The controller 250 provides one or more control signals uich to the charging circuit 140, such that, when an energy pulse is drawn by the load, the charging circuit 140 provides a charging current for an interval tch. Depending on the application, and in particular on the nature of the charging circuit 140, the control signal or signals uich could take a variety of forms. For example, uich could take the form of the timing control signals to high & low-side FETs of a half-bridge DC-DC converter. Ideally, and in order to minimise the charging current, the current should be specified so as to replenish the energy storage device or unit 130 completely just in time for the subsequent energy pulse drawn by the load. That is to say, for a load pulse repetition rate of tp, in steady state tp = tch. Any error, te, between tp and tch is provided back to the controller 250 to adjust the control signal or signals uich to the charging circuit 140. The control loop reacts to changes to average current consumption by the load, and in particular changes to the repetition rate affected tp, or changes to the energy delivery per pulse which may be seen in this control loop as perturbations Qp to the charging circuit.

FIG. 4 shows the effect of the control in the case of a decrease in the repetition rate of load pulses. At 410 is shown a series of intermittent pulses of the load. On the left part of the FIG., shown at 412, the power supply circuit is in steady state and the pulses occur with the periodicity of tp₀, that is to say they have a repetition rate of 1/tp₀. After a few pulses, the repetition rate decreases to 1/tp₁, that is to say they occur with the periodicity of tp₁.

At 420 is shown the voltage vsto at the energy storage device or unit 130. During each load pulse, energy is drained from the storage unit, the voltage of which falls below the fully charged value vref by, in each case, the same voltage drop provided the energy transferred per pulse, Qp, is constant. The charging circuit is enabled since the voltage vsto is less than the reference voltage vref, so between the load pulses, the voltage vsto increases to reach vref just in time for the next load pulse. Plot 430 depicts the charge enable signal en, which thus remains on, or high, throughout this period; the charging circuit 140 is thus permanently on during this period. The charging circuit provides a charging current to the energy storage device or unit 130 of Ich₀, as shown on plot 440.

As shown at 414, the repetition rate of the pulses may decrease to1/tp1, that is to say they occur with the periodicity of tp1. Since tp1 is greater than tp0, and tch0 is equal to tp0, the voltage vsto returns to the reference voltage level vref, prior to the next load pulse. As a result, the charge enable signal en goes low, and the charging circuit 140 is disabled. The voltage vsto at the energy storage device or unit output remains stable at the voltage reference, until the next pulse of the pulsed load occurs at the end of the time period tp1, as shown at 416. During this load pulse, the voltage vsto falls. The time, te, for which the enable signal en is low may then be used as a control parameter to determine the appropriate charging rate at which to control the output charging current Ich1 from the charging circuit 140 such that the voltage vsto will reach the fully, or appropriately to a target level, charged level vref at the end of a subsequent period tp1. Provided the control was previously in a settled state (that is to say, Ich0 = tp0), the charging current can be calculated to be:
$Ich 1 = Ich 0 * \left(tp0/tp1\right) = Ich 0 * \left(tp0/\left(tp0+te\right)\right)$

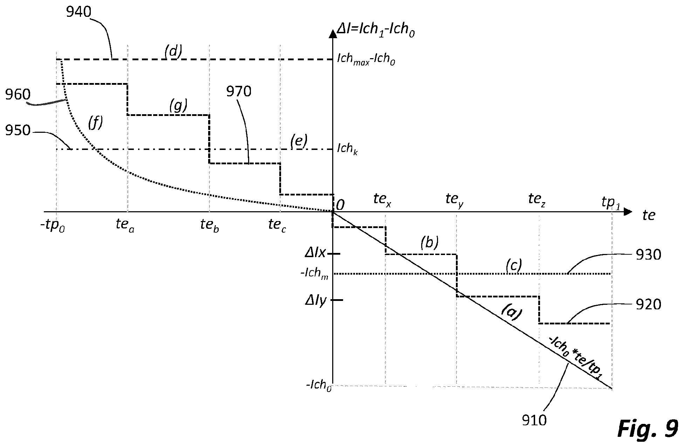

It will be appreciated, that the charging rate is adapted, or changed, so as to match the estimated repetition rate of the pulsed load, based on the previously observed repetition rate. For this and any subsequent reduction in the repetition rate (corresponding to a yet further increase in the time between load pulses), the voltage at the output of the energy storage device will always reach the reference voltage prior to the next pulse. Of course, in the case that there is an increase in the repetition rate the voltage will not reach the reference voltage before the next load pulse. This will be considered more detail with reference to FIG. 9, below. However, for the purposes of the present disclosure, the skilled person will appreciate that, in steady state, the charging current (such as Ich0 or Ich1) is constant. The present inventors have appreciated that this fact, along with the observation that, for a charger or charging circuit 140 which supplies the charging current by means of pulse frequency modulated (PFM) charging pulses from, for example, a DC-DC converter, the PFM frequency may, for the steady-state pulsed load, be indicative of a state of health of the battery 120: besides the load repetition rate, it also inversely depends on the input or battery voltage.

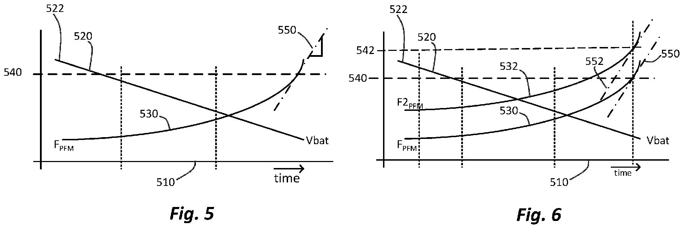

This will now be described with reference to FIG 5. FIG. 5 is a schematic plot over time 510 of a supply voltage of the battery 120 and a PFM frequency of the charging circuit or charger 140. It should be noted that, for FIG. 5 (and for FIG. 6 below), the time-scale is much longer than that shown in FIG. 4. In particular, FIG. 5 may depict the entire lifetime of the battery. That is to say, whereas the timescale in FIG. 4 may be of the order of milliseconds or microseconds, the timescale in FIG. 5 may be of the order of months or years.

The FIG. shows that the supply voltage 520 of the battery 120 falls, monotonically, over time. The skilled person will appreciate that the nature of this decrease depends on the specific type and construction of the battery. In general, the decrease results from a combination of an increasing output impedance of the battery, and the battery itself becoming more depleted (that is to say, its capacity to store energy is reduced. In particular, for some battery types, the decrease may start with a high rate of decrease, drop to a plateau at which the rate of fall is low, and then start to fall quickly towards the end of life of the battery. For other battery types, the decrease may be relatively linear as shown, and for still other battery types, the decrease may have a different profile.

FIG. 5 also shows, at 530, the PFM frequency of the charger or charging circuit 140, which would be required in order to supply a constant charging current, at any time throughout the battery lifetime, as the battery output voltage falls (which may linearly as shown at 520). As the supply voltage from the battery falls, the PFM frequency rises. The skilled person will appreciate that PFM generally corresponds to a discontinuous conduction mode (DCM) in which a pulse of charge is periodically supplied at the pulse frequency. The nature of the pulse may vary according to the specific operation mode (such as peak current control, or on-time control), but irrespective of the specific operation mode, the frequency of the pulses increases as a Vbat decreases, where Vbat is the input of supply voltage (which in this case is from the battery 120). As the battery voltage starts to approach the voltage of the energy storage device, both the magnitude of the PFM frequency, and its rate of change over time, increase as shown in FIG. 5. The present inventors have appreciated that at constant, that is to say fixed, pulsed, load this frequency rate of change may be used to indicate a state of health of the battery, without requirement for complex circuitry. In particular, in one or more embodiments, a threshold frequency (shown at 540 in FIG. 5), may be predetermined. In the event that the operating frequency of the charger exceeds the threshold frequency 540, the controller may provide an end-of-life state indication. Taking into consideration that fact that the variation of the frequency is typically non-linear, in other embodiments, the rate of change of the PFM frequency may be used to provide the end-of-life state indication. One such embodiment is illustrated in FIG. 5 by the gradient or rate of change of the PFM frequency, shown at 550.

The skilled person will appreciate that, in order for FIG. 5 to be correct, the pulsed load, and in particular the product of energy per pulse, Qp, and the repetition rate, requires to be constant. Otherwise, the PFM operating frequency 530 will not show a monotonic increase.

Turning now to FIG. 6, this shows the same plot over time 510 of a supply voltage of the battery 120 and a PFM frequency of the charger or charging circuit 140, for two different pulsed load conditions. The different pulsed load conditions may result from different applications or use cases of the power supply; conversely, they may result from different operating conditions of the same application, for example, from two different pulse magnitudes (that is, energy per pulse, Qp) of the pulsed load, from two different repetition rates of pulses having the same energy per pulse Qp, or from a combination of both differences. The decline in battery supply voltage of 520 is the same as that shown in FIG. 5; the variation of a first PFM operating frequency 530 is the same as that shown in FIG. 5 and corresponds to a same pulsed load condition as that shown in FIG. 5.

However, this FIG. also shows a second variation over time of a PFM operating frequency, F2_{PFM} 532, corresponding to a second pulsed load condition. In the example shown, either the pulses of the pulse load are more frequent, or they have a larger magnitude, or both; in any event the combination of frequency and magnitude results in an increased average load drawn from the energy storage device. As a result, the PFM frequency, F2_{PFM} is generally higher than for the first set of operating conditions shown in FIG. 5. Since F2_{PFM} is generally higher than F_{PFM}, it reaches and exceeds the threshold, 540 earlier in the lifetime of the battery than is the case for F_{PFM}. A separate threshold 542 for these conditions may be predetermined to correspond to the same end-of-life state of the battery. Conversely, as shown in figure 6, the rate of change of the PFM frequency may be the same, irrespective of the magnitude of the load (and thus the magnitude of the PFM frequency at any particular stage of battery life. Thus, in some embodiments, it may be appropriate to rely on a threshold value of the gradient (that is to say to compare the rate of change of the PFM frequency with a threshold rate of change). This is illustrated in FIG. 6, in which it can be seen that the gradient 552 of the PFM frequency F2_{PFM} under the second operating load conditions corresponds to that, 550, of the PFM frequency, F_{PFM}, under the first operating load conditions, at any particular stage of life of the battery. In consequence, the gradient 552 is the same as the grading 550 at the end-of-life state shown. In such cases, a single threshold may be therefore used irrespective of the load conditions of the pulsed load.

The skilled person will appreciate that, whereas in FIG. 6, two different pulsed load operating conditions are shown, the principle may be extended to further load operating conditions, and a corresponding number of thresholds of either or both of the magnitude of the PFM frequency, and the rate of change of the PFM frequency.

The threshold may be predetermined and stored in the health monitor 280, in any suitable form. For example, and without limitation, in a digital implementation, the threshold for several known operating conditions, or operating modes of the same application, may be provided as a lookup table.

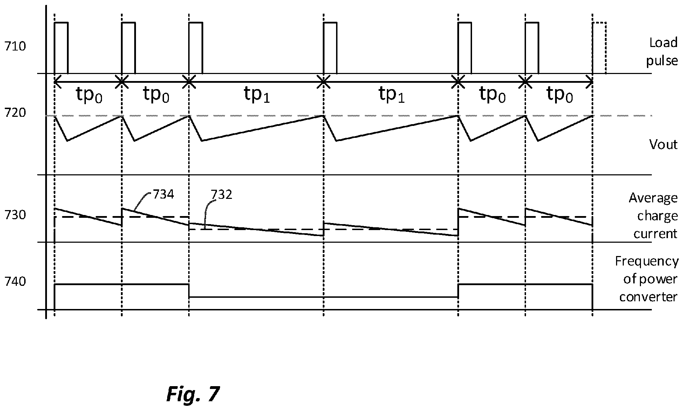

FIG. 7 shows the effect of the variation of the output voltage vout as the energy storage device is charged up between load pulses. In particular the FIG. shows, at 710, the load pulses for two operating modes, a first mode to the left and right of the figure having repetition rate tp₀, and a second node to the centre of the figure having repetition rate tp₁. The output voltage vout of the charger is shown at 720. This voltage falls during the load pulse, and then rises back to the voltage of the fully charged and ready storage device during the interval between pulses whilst the energy storage devices being recharged. In other words, the output vout is equal to vsto. At 740 is shown the frequency of operation of the charger. As described above, the frequency is different for the different operating modes or operating conditions of the pulsed load. At 730 is shown the corresponding charge currents required from the charger. Although a constant current could be supplied as illustrated 732, in practice the output from the charger may fall during the charge interval, as shown at 734, because of the variation in the output voltage shown at 720, the variation of the input battery voltage and the operation of the control of the charger over this period. However, even if the charging current does vary over the charging interval, the PFM charging frequency may be determined just once for each charging interval, at the start of the interval. Provided this measurement is taken at the start of the charging interval, it will still increase over the lifetime of the battery, as described above with respect to figure FIG. 5 and FIG. 6 above.

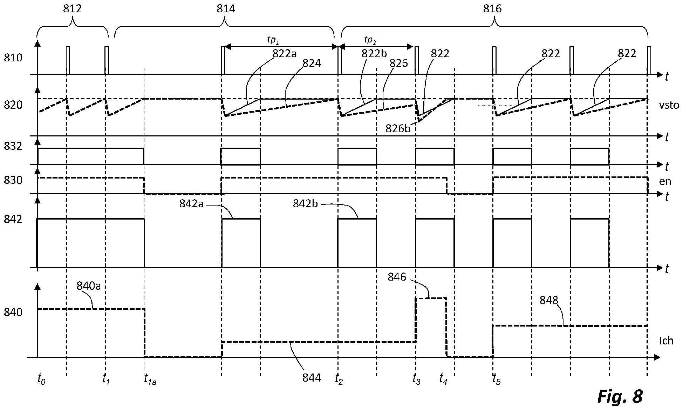

As mentioned above, the method relies on the load being constant, either over the lifetime of the application, or at least for a sufficient time that the appropriate threshold can be set and implemented for the end-of-life comparison. In the latter case, the load may change, and the control mechanism then requires to adjust the charging current Ich to match the new load. One way of implementing this will now be described, with reference to FIG. 8 and FIG. 9.

FIG. 8 shows various signals, illustrating operation of a power supply circuit according to one or more embodiments of the present disclosure. In particular the FIG. shows operation during both an increase and a decrease in the periodicity tp of the load pulses. Similar to FIG. 5, at 810 is shown a series of intermittent pulses of the load. At 820 is shown the voltage vsto at the energy storage device or unit 130, plot 830 depicts the charge enable signal en. For reference, the change in vsto over time according to conventional system is shown at 822, and the charge enable signal EN for a conventional system is shown at 832. At 840 is shown the charging circuit providing a charging current, to the energy storage device or unit 130, of Ich.

The first two time periods shown, at 812 between t₀ and t₁, and 814 between t₁ and t₂, respectively correspond to that shown in FIG. 5. The slower recharge rate, that is to say the lower charging current, which results from a decrease in the repetition rate over time period 814, relative to 812, is visible by the shallower gradient of the recharging 824 according to embodiments of the present disclosure, compared to that 822a in the conventional system. It should be noted that the relatively low battery current, 844, drawn over this period may be beneficial, compared to the charging current from a conventional system as in 842a.

At 816 is shown an increase in the repetition rate of the load pulse (relative to that in time period 814). That is to say, the interval between that load pulses at t₂ and t₃ (or t₃ and t₅) is less than during the time period 814. For a conventional power supply, as shown at 822b, the energy storage device or unit 130 is recharged at the same rate as after any other pulse. And thus the current 842b from the battery or other power source 120 is the same as in the previous intervals, for example as shown at 842a. However, the controller bases the recharge current 826 on the previous periodicity tp₁ (which is longer than the present interval tp₂). As a result, at the end of the interval, when the next load pulse occurs, the energy storage device or unit 130 has not fully recharged to the reference voltage vref. So the next energy pulse drawn from the energy storage device or unit 130 reduces the voltage vsto below the previous minimum voltage, as shown at 826b. To compensate this, the controller modifies uich to increase the charging current, as shown at 846. It will be appreciated that in this instance, because the energy storage device or unit 130 did not fully recharge during the last interval between the load pulses, the increase in charging current must be more than merely to make the current proportional to the repetition rate, in order to fully recharge the energy storage device or unit 130. The voltage vsto thus increases more rapidly back to vref, and once the voltage reaches vref the comparator 260 switches off the enable signal en to stop the charging, as shown at t₄. The skilled person will appreciate that during this interval the battery must supply a greater power level than would be the case for fixed battery current situation.

Once the next load pulse occurs, since the energy storage device or unit 130 is fully recharged, the controller may set the charging current to be proportional to the previous repetition rate (that is to say inversely proportional to the time interval between t₃ and t₅). This current level, as shown at 848, is thus lower than the level 846 resulting from the need to recover the missing energy at t3, however it is higher than the current level 844, as the new repetition rate 816 is higher than in the time period 814.

It will be appreciated that various alternative implementations of the above adaptation concept may be implemented. Considering first the situation where the repetition rate of load pulses has decreased, relative to a previous repetition rate (which may typically, but not necessarily, be steady-state) such that tch < tp. Without limitation, at least three alternative methods may be adopted to adjust the recharging current. Various alternatives will be discussed now, with reference to the right-hand side of FIG. 9. FIG. 9 plots the change, ΔI, in charging current between successive load pulses, ie ΔI = Ich₁ - Ich₀, against value or magnitude of the change te in the repetition rate, for various control methods according to embodiments of the present disclosure.

A first method "(a)", shown at 910, is as described above: the secondary loop may be configured to measure the time between load pulses (tp) and the charging time (tch) using for example an external clock clk as shown in FIG. 2 or an internal time reference. As described above, the time difference te may be calculated since te = tp - tch, and the charging current modified in proportion to the difference, as indicated in equation (1):
${Ich}_{1} = {Ich}_{0} * \left({tp}_{0}/{tp}_{1}\right) = {Ich}_{0} * \left({tp}_{0}/\left({tp}_{0}+te\right)\right)$
or equivalently:
${Ich}_{1} = {Ich}_{0} * \left(1-te/{tp}_{1 _}\right) .$

In a second method "(b)", shown at 920, the charging current may be reduced by a stepped amount in response to te being above or below predetermined threshold levels. Thus for example if the value of te is between teₓ and te_{y}, the charging current may be changed by a first amount ΔIₓ, if the value of te is between te_{y} and te_{z}, the charging current may be changed by a second amount ΔI_{y}, and so on.

In a third method, "(c)", shown at 930, the charging current could be reduced by a fixed amount based simply on the sign of te (in other words whether te is negative). This method is particularly simple and may be easy to implement since there would be no need to remeasure any time magnitude, rather, it would be necessary merely to observe whether the charging process is completed or not before the next load pulse is triggered. However, the solution may result "bouncing", or limit cycle oscillations around the optimal value which may be detrimental in some applications, and might result in a longer settling time of the secondary loop compared to other embodiments, resulting in a longer time interval over which the charging of the energy storage device or unit 130 is suboptimal.

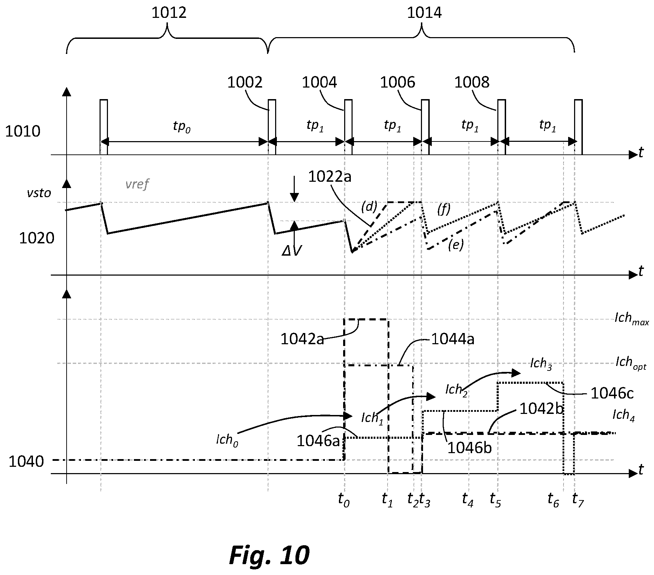

We turn now to situations in which the repetition rate of load pulses has increased relative to a previous repetition rate (which may typically, but not necessarily, be steady-state) such that tch > tp. This change is somewhat more complicated in that the charging rate which was optimal for the previous repetition rate does not completely charge the energy storage device or unit 130. Consequently, the charging time tch, required to fully recharge the energy storage device, is unknown because the charging process was not completed. Again, various methods may be implemented according to the present disclosure some, of which will be described in more detail with reference to the left-hand side of FIG. 9, and FIG. 10.

FIG. 10 shows various signals similar to those in FIG. 6, resulting from a decrease in the periodicity tp of the load pulses. At 1010 is shown a series of intermittent pulses of the load, initially at a periodicity of tp₀ over time period 1012, and then changing to a reduced periodicity of tp₁, corresponding to an increased repetition rate. At 1020 is shown the voltage vsto at the energy storage device or unit 130, and at 1040 is shown the charging circuit providing a charging current, to the energy storage device or unit 130, of Ich.

During a first time interval, the charging current is optimised for the periodicity tp₀ of the load pulses, such that the voltage vsto on the energy storage device or unit 130 reaches the reference value vref just in time for the load pulse 1002. The controller continues to recharge the energy storage device or unit 130 at the same rate during the next interval; however, since this interval, tp₁, until the next load pulse 1004 is shorter than the prior interval, vsto does not fully recover to vref but is lower by a value ΔV, as shown. Various alternative control methods according to one or more embodiments may now be implemented. In one method, (d), shown at 940, it is detected that the load pulse is triggered while the charging circuit is still enabled. The maximum charging current Ichₘₐₓ is selected by the controller so that the voltage vsto on the energy storage device or unit 130 increases at the fastest rate, in order to ensure that vsto reaches the reference level vref before the next subsequent load pulse. As shown in FIG. 9, the increase in the charging current is then Ichₘₐₓ - Ich₀. And as shown in FIG. 10, the current 1042a results in a relatively fast rise of vsto, as shown at 1022a, so that it reaches the reference voltage vref at a time t1 where t1 <t3 (t3 being the start of the next subsequent load pulse 1006). For the following pulse 1008, the period tp₁ is now known, so provided that the subsequent pulses occur with a steady state periodicity, the current charging level 1042b may be set so that vsto is restored to vref just at the moment the next load pulse 1008 occurs at moment t5. To enable this, the maximum charging current, Ichₘₐₓ, should be significantly larger than the maximum required by the load at the highest anticipated repetition rate. As a result, a maximum, or relatively high current is drawn from the power supply or battery 120, during the period from t₀ to t₁. However, this would only be for a single period, so any associated degradation of the battery could be expected to be relatively light.

An alternative method, "(e)", is shown at 950 in FIG. 9. In this case, if the energy storage device or unit 130 is not fully charged before the load is triggered, the charging current is simply increased each cycle, by an amount Ichₖ, which is either fixed (as shown), or depends linearly or non-linearly on ΔV. In the case of the fixed increase, it may take several load pulse intervals in order to fully recharge the energy storage device or unit 130, and at the start of each interval the charging current increases, as shown, from Ich₀ → Ich₁ (946a) → Ich₂ (946b)→ Ich₃ (946c). This could result in longer settling time to an optimum charging current value, but would normally avoid requiring to use the maximum charging current.

A further alternative method, "(f)", is shown at 960 in FIG. 9. In these cases, an optimum charging current, Ichₒₚₜ, to reach vref at the end of the time interval tp₁ may be determined as shown at 1044a in FIG. 10, by use of additional information. For example, in a first case, if the capacitance value Csto the energy storage device or unit 130 and the voltage difference (ΔV), between the target recharge level vref and the actual vsto at the moment that a new load event is triggered, are known, Ich, could be computed from:
${Ich}_{1} = {Ich}_{0} + \left(2.ΔV.Csto\right) / {tp}_{1}$

It will be appreciated that this method requires a relatively accurate measurement of ΔV, and that Csto needs to be known to, or calculable by, the controller. The latter could be achieved, for instance by, or perhaps using indirect measurement based on, the slopes of vsto.

In a second case, the new optimum charging current, Ich₁, could be calculated with reference to the previous charging current Ich₀, through
${Ich}_{1} = {Ich}_{0} . \left\{2\left({tp}_{0}/{tp}_{1}\right)-1\right\}$

It will be appreciated that this method requires the storage of the previous interval tp₀. Offset against this is the potential advantage that the optimum charging current is found to give the shortest settling time.

The skilled person will appreciate that the second of these two cases is quite similar to the opposite or inverse of situation "(a)" for an increase of periodicity between load pulses shown in FIG. 4. Whereas when tch < tp (case "(a)"), both can be known as the charging process had time to end, in case of tch > tp the charging time is not known because the charging process was truncated before finishing by a load pulse (or at least its measurement is heavily distorted by it). Thus in "(f)", in absence of a known *tch, tp₀* (time between 2 previous load events) is used, although this is based on the assumption that the loop was well settled (tp0 being equal or very close to tch0), which may not always be the case.

In a yet further example "(g)" 970, by measuring tp₁ and storing tp₀, different constant values could be used to increase Ich₀ based on the difference tp₁-tp₀ positioned against different threshold values. Again, as in the other left-hand side methods of FIG. 9, te is in practice tp1-tp0, because tch, that is the time to fully recharge the energy storage device, is not known.

As already mentioned and as will be familiar to those skilled in the art of process control loops, it may be appropriate to increase the charging current by slightly more than the optimum value and/or apply a hysteresis around the te=0 point in order to ensure the system settles without bouncing oscillation. Also, again as has been referred to hereinabove, in the case that tp<tch, the energy storage device or unit 130 may not be fully recharged between load pulses, and as a result the worst case drop in vsto may be greater than that in a conventional system. This should be taken into account when designing the whole system: the energy storage device or unit 130 should be able to supply more than one load pulse, without requiring to be refilled. It will be further appreciated that, for implementations in which the controller, and thus a secondary loop, can be pre-informed about an anticipated change in the repetition rate of load pulses, this information may be used by the controller in order to reduce the transients of this secondary loop.

Although the present disclosure has been illustrated by use of rectangular pulses for the pulse load, the skilled person will appreciate that the present disclosure is not limited thereto. For example and without limitation, the load pulses may be triangular, trapezoidal, or have a more complex time profile.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. FIG. s are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated or constructed to achieve the same or a similar purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features or aspects from one or more embodiments can be combined with one or more features or aspects of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

Less than all of the steps or functions described with respect to the exemplary processes or methods can also be performed in one or more of the exemplary embodiments. Further, the use of numerical terms to describe a device, component, step or function, such as first, second, third, and so forth, is not intended to describe an order or function unless expressly stated so. The use of the terms first, second, third and so forth, is generally to distinguish between devices, components, steps or functions unless expressly stated otherwise. Additionally, one or more devices or components described with respect to the exemplary embodiments can facilitate one or more functions, where the facilitating (e.g., facilitating access or facilitating establishing a connection) can include less than every step needed to perform the function or can include all of the steps needed to perform the function.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

## Claims

1. A power supply circuit, for a pulsed load (210) and comprising:
a battery (120);
an energy storage device (130), connected to an output of the power supply circuit and configured to provide periodic current pulses to the load at a repetition interval;
a charger (140) connected, at an input thereof, to the battery, and at an output thereof to the energy storage device, and configured to provide a charging current to the energy storage device;
a charge controller (250), configured to control the charging current by controlling an operating frequency of the charger, and to determine an optimised charger operating frequency at which the energy storage device is recharged over the pulse interval; and
a health monitor (280) configured to at least one of: compare the optimised charger operating frequency with a threshold frequency and indicate an end-of-life state of the battery in response to the optimised charger operating frequency exceeding the threshold frequency; and compare a rate-of-change of the optimised charger operating frequency with a threshold rate-of-change and indicate an end-of-life state of the battery in response to the rate-of-change of the optimised charger operating frequency exceeding the threshold rate-of-change.

2. The power supply circuit according to claim 1, wherein the energy storage device is a capacitor.

3. The power supply circuit according to claim 1 or 2, wherein the charger is a DC-DC converter, and the charge controller is configured to operate the DC-DC converter in a pulse frequency modulation, PFM, mode.

4. The power supply circuit according to claim 3, wherein the PFM mode comprises a constant on-time.

5. The power supply circuit according to any preceding claim, wherein the charge controller is configured to determine the optimised charger operating frequency at a start of each load pulse.

6. The power supply circuit according to any preceding claim, wherein the power supply circuit is for an additional load, which, over the repetition period, is less than one quarter of the pulsed load.

7. The power supply circuit according to any preceding claim, in which the health monitor compares the optimised charger operating frequency with a threshold frequency, wherein the threshold frequency is a pre-determined multiple of a start-of-life optimised operating frequency.

8. The power supply circuit according to any preceding claim, in which the health monitor compares the rate-of-change of the optimised charger operating frequency with a threshold rate-of-change, wherein the rate-of-change of the threshold frequency is a pre-determined multiple of a start-of-life rate-of-change of the optimised charger operating frequency.

9. A method of detecting a health state of a battery, in a power supply circuit having a charger and an energy storage device and for a pulsed load having a repetition interval, the method comprising:
controlling a charging current of the energy storage device, by controlling an operating frequency of the charger, to recharge the energy storage device over the repetition interval at an optimised charger operating frequency;
at least one of: comparing the optimised charger operating frequency with a threshold frequency, and comparing a rate-of-change of the optimised charger operating frequency with a threshold rate-of-change; and
indicating an end-of-life state of the battery in response to at least one of: the optimised charger operating frequency exceeding the threshold frequency, and the rate-of-change of the optimised charger operating frequency exceeding the threshold rate-of-change.

10. The method of claim 9, wherein the repetition interval is a first repetition interval, and the at least one of a threshold frequency and a threshold rate-of-change are a first threshold frequency and a first threshold rate-of-change respectively, the pulsed load further having a second repetition interval, for which the at least one of a threshold frequency and a threshold rate-of-change are a second threshold frequency and a second threshold rate-of-change respectively.

11. The method of claim 10, wherein the second threshold rate-of-change is equal to the first threshold rate-of-change.

12. The method of any of claims 9 to 11, wherein the energy storage device is a capacitor.

13. The method of any of claims 9 to 12, wherein the charger is a DC-DC converter, and controlling the charger comprises operating the DC-DC converter in a pulse frequency modulation, PFM, mode.

14. The method of claim 13, wherein the PFM mode comprises a constant on-time.

15. The method of claim 13 or 14, wherein the DC-DC converter is operating in discontinuous conduction mode, DCM, having a variable idle-time.

## Amended claims

### Amended claims in accordance with Rule 137(2) EPC.

1. A power supply circuit, for a pulsed load (210) and comprising:
a battery (120);
an energy storage device (130), connected to an output of the power supply circuit and configured to provide periodic current pulses to the load at a repetition interval;
a charger (140) connected, at an input thereof, to the battery, and at an output thereof to the energy storage device, and configured to provide a charging current to the energy storage device;
a charge controller (250), configured to control the charging current by controlling an operating frequency of the charger, and to determine an optimised charger operating frequency, being the operating frequency at which the energy storage device is recharged over the pulse interval; and
a health monitor (280) configured to at least one of: compare the optimised charger operating frequency with a threshold frequency and indicate an end-of-life state of the battery in response to the optimised charger operating frequency exceeding the threshold frequency; and compare a rate-of-change of the optimised charger operating frequency with a threshold rate-of-change and indicate an end-of-life state of the battery in response to the rate-of-change of the optimised charger operating frequency exceeding the threshold rate-of-change.

2. The power supply circuit according to claim 1, wherein the energy storage device is a capacitor.

3. The power supply circuit according to claim 1 or 2, wherein the charger is a DC-DC converter, and the charge controller is configured to operate the DC-DC converter in a pulse frequency modulation, PFM, mode.

4. The power supply circuit according to claim 3, wherein the PFM mode comprises a constant on-time.

5. The power supply circuit according to any preceding claim, wherein the charge controller is configured to determine the optimised charger operating frequency at a start of each load pulse.

6. The power supply circuit according to any preceding claim, wherein the power supply circuit is for an additional load, which, over the repetition period, is less than one quarter of the pulsed load.

7. The power supply circuit according to any preceding claim, in which the health monitor compares the optimised charger operating frequency with a threshold frequency, wherein the threshold frequency is a pre-determined multiple of a start-of-life optimised operating frequency.

8. The power supply circuit according to any preceding claim, in which the health monitor compares the rate-of-change of the optimised charger operating frequency with a threshold rate-of-change, wherein the rate-of-change of the threshold frequency is a pre-determined multiple of a start-of-life rate-of-change of the optimised charger operating frequency.

9. A method of detecting a health state of a battery, in a power supply circuit having a charger and an energy storage device and for a pulsed load having a repetition interval, the method comprising:
controlling a charging current of the energy storage device, by controlling an operating frequency of the charger, to recharge the energy storage device over the repetition interval at an optimised charger operating frequency;
at least one of: comparing the optimised charger operating frequency with a threshold frequency, and comparing a rate-of-change of the optimised charger operating frequency with a threshold rate-of-change; and
indicating an end-of-life state of the battery in response to at least one of: the optimised charger operating frequency exceeding the threshold frequency, and the rate-of-change of the optimised charger operating frequency exceeding the threshold rate-of-change.

10. The method of claim 9, wherein the repetition interval is a first repetition interval, and the at least one of a threshold frequency and a threshold rate-of-change are a first threshold frequency and a first threshold rate-of-change respectively, the pulsed load further having a second repetition interval, for which the at least one of a threshold frequency and a threshold rate-of-change are a second threshold frequency and a second threshold rate-of-change respectively.

11. The method of claim 10, wherein the second threshold rate-of-change is equal to the first threshold rate-of-change.

12. The method of any of claims 9 to 11, wherein the energy storage device is a capacitor.

13. The method of any of claims 9 to 12, wherein the charger is a DC-DC converter, and controlling the charger comprises operating the DC-DC converter in a pulse frequency modulation, PFM, mode.

14. The method of claim 13, wherein the PFM mode comprises a constant on-time.

15. The method of claim 13 or 14, wherein the DC-DC converter is operating in discontinuous conduction mode, DCM, having a variable idle-time.
